# EUROPEAN PATENT APPLICATION

(11) **EP 4 554 339 A1**
(43) Date of publication of application: **14.05.2025**
(21) Application number: 23208992.0
(22) Date of filing: 10.11.2023
(51) Int. Cl.: H05K 1/03, H05K 1/18, H05K 3/46, H05K 3/00, H05K 3/16

(54) **COMPONENT CARRIER WITH EMBEDDED COMPONENT AND GAP FILLED WITH FIBER-FREE RESINS**

(71) Applicant: AT & S Austria Technologie & Systemtechnik Aktiengesellschaft, 8700 Leoben-Hinterberg (AT)
(72) Inventor: Wilding, Dominik, 8720 Knittelfeld (AT)
(74) Representative: Dilg, Haeusler, Schindelmann Patentanwaltsgesellschaft mbH

(57) **Abstract**

A component carrier (100) which comprises a stack (102) comprising a layer body (104), a fiber-free first electrically insulating layer structure (106) including a first resin (108) on a bottom main surface on the layer body (104), and a fiber-free second electrically insulating layer structure (110) including a second resin (112) on a top main surface of the layer body (104), and a component (114) inserted in a cavity (116) of the stack (102), wherein at least part of a gap (118) between the component (114) and sidewalls (154) of the stack (102) delimiting the cavity (116) is filled partially with the first resin (108) and partially with the second resin (112).

## Description

The invention relates to a component carrier, and a method of manufacturing a component carrier.

In the context of growing product functionalities of component carriers equipped with one or more electronic components and increasing miniaturization of such components as well as a rising number of components to be mounted on or embedded in the component carriers such as printed circuit boards, increasingly more powerful array-like components or packages having several components are being employed, which have a plurality of contacts or connections, with ever smaller spacing between these contacts. Removal of heat generated by such components and the component carrier itself during operation becomes an increasing issue. At the same time, component carriers shall be mechanically robust and electrically reliable so as to be operable even under harsh conditions.

For embedding a component in a layer stack, a through hole can be formed in the layer stack and can be closed from a bottom side by a temporary carrier such as an adhesive tape. A dielectric layer may be formed on top of the stack and the component. Thereafter, the temporary carrier is released. Also structures comprising copper may be created. Mechanically fixing and electrically connecting an embedded component in a reliable manner is however still a challenge.

EP 3,081,056 B1 discloses a method for embedding a component into a printed circuit board or a printed circuit board intermediate product, wherein the printed circuit board or printed circuit board intermediate product has at least one insulating layer of a prepreg material and the component is fixed by the resin of the prepreg material, the method having a sequence of providing a composite of the layers of the printed circuit board or printed circuit board intermediate product, wherein the composite of the layers of the printed circuit board or printed circuit board intermediate product consists of a plurality of layers of a curable prepreg material and external copper layers on both sides, producing a clearance in the composite for receiving the component to be embedded, covering at least the region of the clearance with a first temporary carrier layer on a first side of the composite, positioning the component to be embedded in the clearance by means of the first temporary carrier layer, covering at least the region of the clearance on the second side of the composite with a second temporary carrier layer, compressing the composite with the component while curing the curable prepreg material, and removing the temporary carrier layers.

There may be a need for a component carrier with embedded component being manufacturable simply and with high reliability.

According to an exemplary embodiment of the invention, a component carrier is provided, wherein the component carrier comprises a stack comprising a layer body, a fiber-free first electrically insulating layer structure including a first resin on a bottom main surface on the layer body, and a fiber-free second electrically insulating layer structure including a second resin on a top main surface of the layer body, and a component inserted in a cavity of the stack, wherein at least part of a gap between the component and sidewalls of the stack delimiting the cavity is filled partially with the first resin and partially with the second resin.

According to another exemplary embodiment of the invention, a method of manufacturing a component carrier is provided, wherein the method comprises forming a stack by arranging a fiber-free first electrically insulating layer structure including a first resin on a bottom main surface of a layer body, and by arranging a fiber-free second electrically insulating layer structure including a second resin on a top main surface of the layer body, forming a cavity in the stack, inserting a component in the cavity of the stack, and filling at least part of a gap between the component and sidewalls of the stack delimiting the cavity partially with the first resin and partially with the second resin.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote an arrangement of multiple planar layer structures which are mounted in parallel on top of one another.

In the context of the present application, the term "layer body" may particularly denote a flat or planar sheet-like body which may comprise one or more electrically insulating layers. For instance, the layer body may be a layer stack, in particular a laminated layer stack or a laminate. Such a laminate may be formed by connecting a plurality of layer structures by the application of mechanical pressure and/or heat. In an example, at least part of the layer body may comprise mechanically reinforcing structures, for example glass cloth or glass fibers. These glass structures may form a mesh, one or more mesh structures may be stacked on each other and may thereby form a mechanically stable construction.

In the context of the present application, the term "layer structure" may particularly denote a continuous layer, a patterned layer or a plurality of nonconsecutive islands within a common plane.

In the context of the present application, the term "fiber-free electrically insulating layer structure" may particularly denote a layer structure made of an electrically insulating material and being free of reinforcing fibers, such as glass fibers. For example, such a fiber-free electrically insulating layer structure may comprise resin (for instance epoxy resin), optionally filler particles (such as ceramic beads or spheres), and optionally one or more additives (such as an adhesion promoter, a stabilizer, etc.).

In the context of the present application, the term "resin" may particularly denote a solid or liquid synthetic or natural organic polymer. An example for a resin is an epoxy resin. For instance, the resin may be a thermosetting resin.

In the context of the present application, the term "component" may particularly denote any bulky rather than layer-type block. The component may be an electronic component, such as an active (for example a semiconductor chip or semiconductor package) or passive (for instance a capacitor or an inductor) electronic component embedded or to be embedded within an interior of the component carrier. However, the component may also be a non-electronic component without electronic functionality. For example, the component may be a component with thermal functionality, such as a heat removal and/or heat spreading functionality. For example, the component may be a metal (for instance copper) block and/or ceramic block. Hence, exemplary embodiments may be implemented with one or more electronic components or with any other bulk metal structures (for instance for heat transfer) or inlays (for example inorganic inlays such as glass).

In the context of the present application, the term "cavity" may particularly denote a recess, groove or hole (in particular blind hole or through hole) extending through and/or into the stack. Preferably, all the sides of the cavity may be defined by layer structures of the stack.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

According to an exemplary embodiment, a component carrier (such as a printed circuit board) has a (for example laminated) layer stack. A central layer body (for instance a core) can be sandwiched between a bottom-side fiber-free first electrically insulating layer structure having a first resin and a top-sided fiber-free second electrically insulating layer structure having a second resin. At least one component may be embedded in a cavity of the stack. A first portion of a lateral gap between the component and cavity-delimiting sidewalls of the stack may be filled with the first resin from the fiber-free first electrically insulating layer structure. Moreover, a second portion of the lateral gap between the component and cavity-delimiting sidewalls of the stack may be filled with the second resin from the fiber-free second electrically insulating layer structure. Advantageously, such an architecture of the component carrier with embedded component allows a reliable and accurate component fixation with a resin flow from two opposing horizontal planes upwardly and downwardly into the gap between component and stack in a symmetrical way. By such a design, very thin package-type component carriers can be realized. With such a manufacturing concept, there are no limitations in terms of component miniaturization. Moreover, a very short signal path may be achieved due to a possible direct component connection. In view of the symmetric stack construction, undesired phenomena such as warpage and delamination may be reliably prevented.

Advantageously, the first resin and the second resin may be fiber free. This brings the advantage of having lower roughness. Consequently, smaller traces can be patterned on the exposed surface of the stack. This may enable miniaturization with copper line space ratio of 1 µm/1 µm or below. Furthermore, evenness may be improved by fiber-less resin layers compared with layers having fibers.

In the following, further exemplary embodiments of the component carrier and the manufacturing method will be explained.

Advantageously, the component carrier may be formed with an electrically conductive layer formed directly on at least one of the first electrically insulating layer structure and the second electrically insulating layer structure. Preferably, said electrically conductive layer may be realized by an additive or semi-additive process. By avoiding, in an embodiment, copper foils on the first electrically insulating layer structure and/or the second electrically insulating layer structure, no structuring of copper foils needs to be performed by a subtractive process such as etching which is not optimum for fine-line structures. However, such fine traces can be realized with excellent quality by an additive or semi-additive process. Thus, preferred embodiments of the present invention may use temporary layers for lamination.

In an embodiment, the layer body is a core, in particular a core with a fully cured resin. In the context of the present application, the term "core" may particularly denote a rigid plate structure for a component carrier comprising a preferably fully cured dielectric body (such as a central plate) which may be optionally covered on one or both opposing main surfaces thereof with a respective electrically conductive layer structure such as a patterned metal layer. Additionally or alternatively, the core may comprise a glass and/or a ceramic plate structure, in particular at least portions of the core may comprise a glass and/or a ceramic plate structure. For instance, the dielectric body may comprise resin (for instance epoxy resin) and reinforcing particles (for instance glass fibers or glass spheres), and may for instance be FR4. Optionally, two opposing main surfaces of a core may be electrically coupled with each other by a vertical through connection such as a copper plated laser via or a mechanically drilled and copper plated via. More specifically, a core of a component carrier such as a printed circuit board (PCB) may be a rigid base material being optionally laminated with copper on one or two sides. Such a core may be used for manufacturing single-sided and double-sided boards, but may also be used in the production of multi-layer component carriers (in particular PCBs).

As an alternative, the layer body may be another layer stack than a core. For example, the layer body may be a layer stack comprising one or more electrically conductive layer structures and/or one or more electrically insulating layer structures.

In an embodiment, the first electrically insulating layer structure has a roughness Ra in a range from 10 nm to 800 nm, in particular in a range from 20 nm to 400 nm, on a main surface facing away from the layer body. Due to the fiber-free property of the first electrically insulating layer, a very smooth surface may be obtained below the first electrically insulating layer. What concerns the first electrically insulating layer structure, the roughness of its main surface facing away from the layer body may be lower than the roughness of its other main surface facing the layer body. Hence, the main surface facing away from the layer body may be a smoother surface, whereas the other main surface facing the layer body may be a rougher surface than that facing away from the layer body. Furthermore, a temporary lamination foil (such as a sticky tape) and/or a dielectric separation foil may be connected with the first electrically insulating layer structure and may be used for influencing the roughness features thereof.

In an embodiment, the second electrically insulating layer structure has a roughness Ra in a range from 10 nm to 800 nm, in particular in a range from 20 nm to 400 nm, on a main surface facing away from the layer body. Due to the fiber-free property of the second electrically insulating layer, a very smooth surface may be obtained on top of the second electrically insulating layer. What concerns the second electrically insulating layer structure, the roughness of its main surface facing away from the layer body may be lower than the roughness of its other main surface facing the layer body. The main surface facing away from the layer body may be a smoother surface, whereas the other main surface facing the layer body may be a rougher surface than that facing away from the layer body.

Referring to the aforementioned embodiments, a very smooth exposed surface may be obtained at the fiber-free first and/or second electrically insulating layer structure. This may make it possible to form very thin and narrow as well as precisely defined electrically conductive traces with very high integration density on the exterior smooth surface of the respective fiber-free electrically insulating layer structure. Moreover, such electrically conductive traces formed (in particular directly) on a very smooth surface of the respective fiber-free first and/or second electrically insulating layer structure may lead to a significantly improved high frequency (RF) and/or high-speed behavior. To put it shortly, the skin effect may lead to a current flow only within a thin surface-sided skin of an electrically conductive trace at high signal frequencies. Consequently, a smoother surface may lead to lower losses in view of said skin effect.

In an embodiment, the component carrier comprises a first electrically conductive fine line pattern on a main surface of the first electrically insulating layer structure facing away from the layer body. Such a fine line pattern may comprise electrically conductive traces and/or electrically conductive pads on, preferably directly on, the smoother of the two opposing main surfaces of the first electrically insulating layer structure. Due to the pronounced smoothness of said surface due to the absence of fibers, thin and tiny fine line structures may be created thereon, for example by sputtering or plating followed by patterning.

In an embodiment, the component carrier comprises a second electrically conductive fine line pattern on a main surface of the second electrically insulating layer structure facing away from the layer body. Also such a fine line pattern may comprise electrically conductive traces and/or electrically conductive pads on, preferably directly on, the smoother of the two opposing main surfaces of the second electrically insulating layer structure. Due to the pronounced smoothness of said surface due to the absence of fibers, thin and tiny fine line structures may be created thereon, for example by sputtering or plating followed by patterning.

In an embodiment, the first fine line pattern and/or the second fine line pattern comprises an electrically conductive trace having a width in a range from 1 µm to 15 µm, for example in a range from 1.5 µm to 8 µm. Additionally or alternatively, a distance between adjacent traces may be in a range from 1 µm to 15 µm, for example in a range from 1.5 µm to 8 µm. Such extremely tiny structures may lead to low loss of electric signals propagating thereon and may allow to obtain an excellent density of traces, i.e. number of traces per area or volume of the component carrier.

In an embodiment, the first electrically insulating layer structure includes first filler particles. Additionally or alternatively, the second electrically insulating layer structure includes second filler particles. Thus, the first resin and/or the second resin may be mixed with filler particles. The filler particles of the first resin and the second resin may be the same or may differ concerning at least one property, such as material and/or material distribution, size and/or size distribution, shape, hollow, solid or porous character, and/or amount of the respective filler particles. For instance, said filler particles may be added to the respective resin to provide at least one additional functionality, such as an enhancement of thermal conductivity, an electric shielding function, enhancement of electric isolation, etc. When the respective resin is mixed with filler particles, the respective portion of the gap between component and cavity sidewalls may comprise a mixture of the respective resin with the assigned filler particles.

In an embodiment, the component carrier comprises an electrically conductive layer (for example a sputtering layer or a plating layer) formed directly on at least one electrically conductive pad of the component and/or formed directly on at least one of the first electrically insulating layer structure and the second electrically insulating layer structure. Correspondingly, the method may comprise sputtering an electrically conductive sputtering layer directly on at least one pad of the component and/or directly on at least one of the first electrically insulating layer structure and the second electrically insulating layer structure. Thus, the electrically conductive sputtering layer may be formed by a sputtering process. Sputtering may denote a process in which microscopic particles of a solid material are ejected from its surface, after the material is itself bombarded by energetic particles of a plasma or gas. By such a sputtering process, a metal may be deposited directly on the respective electrically insulating layer structure and/or on electrically conductive pads of the component. Additionally and/or alternatively, other additive processes, for example chemical vapor deposition or other kinds of physical vapor deposition, may be used. In view of the very smooth exposed surface of the respective electrically insulating layer structure, fine line patterning becomes possible on both opposing main surfaces of the component carrier based on such a sputtering layer. This may allow to electrically contact pads on one or both opposing main surfaces of the component. Alternatively, the method may comprise plating (for instance electroless plating followed by electroplating) an electrically conductive plating layer directly on at least one pad of the component and/or directly on at least one of the first electrically insulating layer structure and the second electrically insulating layer structure.

In one embodiment, the component comprises one or more pads on a bottom main surface thereof. Such a component may be denoted as facedown component. In another embodiment, the component comprises one or more pads on a top main surface thereof. Such a component may be denoted as face-up component. In still another embodiment, the component comprises one or more pads on a bottom main surface thereof and one or more pads on a top main surface thereof. Such a component may be denoted as component with double-sided electric connections. Advantageously, a manufacturing process according to an exemplary embodiment of the invention may allow to precisely electrically contact a component of any of the three alternatives. In particular, at least part of said pads may remain exposed after curing the first resin of the first electrically insulating layer structure and the second resin of the second electrically insulating layer structure. The other part of said pads may be connected by a via connection, such as laser vias. This may facilitate the establishment of an electric coupling of said pads with a metallic layer structure formed thereon.

In an embodiment, said electrically conductive layer (for instance sputtering layer or plating layer) comprises an adhesion promoter sublayer and a metallic layer thereon. Preferably, such an adhesion promoter sublayer is electrically conductive, although it may be electrically insulating in other embodiments. Advantageously, an adhesion promoter sublayer may promote adhesion between the respective electrically insulating layer structure and/or one or more pads of the component on the one hand, and a wiring structure thereon comprising electrically conductive traces on the other hand. Such an adhesion promoter sublayer may enhance integrity of the component carrier as a whole and may suppress undesired effects such as delamination. It may help applied metallic material to adhere during sputtering or plating and thereafter.

In an embodiment, the component has at least one electrically conductive pad which is made of another material than copper. Since the direct electric contacting of one or more exposed component carrier pads can be accomplished by sputtering or plating, there is a freedom of choice concerning the material of the component pad(s), which is not limited to copper. However, it is also possible to connect copper pads of the components according to exemplary embodiments.

In an embodiment, a thickness of at least one of the first electrically insulating layer structure and the second electrically insulating layer structure is in a range from 5 µm to 100 µm, for example in a range from 10 µm to 50 µm. Thus, ultra-thin electrically insulating layer structures may be provided as resin reservoirs. At the same time, such thin electrically insulating layer structures may promote an overall vertical compactness of the component carrier. More generally, a thickness of at least one of the first electrically insulating layer structure and the second electrically insulating layer structure may be up to 250 µm. To put it shortly, the bigger the volume to be filled, the bigger the thickness of the respective insulating layer structure can be.

In an embodiment, a thickness of the layer body is in a range from 15 µm to 500 µm, in particular in a range from 20 µm to 100 µm. Hence, also the layer body, preferably embodied as core, may be of small thickness which may result in an overall compact component carrier with embedded component, such as a semiconductor die. More generally, a thickness of the layer body may be up to 800 µm.

In an embodiment, the first electrically insulating layer structure and the second electrically insulating layer structure are made of the same material. In an example, the resin material of the first electrically insulating layer and the second electrically insulating layer may be the same. In another example, a filler material and/or a size and/or a shape of filler particles of the first electrically insulating material and the filler material of the second electrically insulating material may be the same. Nevertheless, an interface between the first resin and the second resin may be present, and may for instance be visible in a cross-sectional view. The same resin of the first electrically insulating layer structure and the second electrically insulating layer structure may lead to homogeneous properties inside of the component carrier and may thus suppress undesired phenomena such as warpage, delamination, CTE (coefficient of thermal expansion) mismatch, etc.

In a preferred embodiment, the resin of the first electrically insulating layer structure and the resin of the second electrically insulating layer structure as well as resin of the layer body may be the same. Advantageously, this may lead to a very homogenous build-up structure resulting, in turn, in low warpage and a low risk of delamination.

In another embodiment, the first electrically insulating layer structure and the second electrically insulating layer structure are made of different materials. In an example, the resin material or resin material composition of the first electrically insulating layer and the second electrically insulating layer may be different. In another example, a filler material and/or a size and/or a shape of filler particles of the first electrically insulating material and of the second electrically insulating material may different. The individual selection of the different materials may allow to fine-tune the properties of the component carrier and its individual constituents, even in a spatially resolved way.

In an embodiment, a material composition of the first electrically insulating layer structure on the layer body and on the component is the same as in a connected portion of the gap. This may be a fingerprint of the fact that the first electrically insulating layer structure may be the resin source for filling the corresponding part of the gap. For example, the first electrically insulating layer structure may comprise fillers. For instance, said fillers may also be provided in the gap.

In an embodiment, a material composition of the second electrically insulating layer structure on the layer body and on the component is the same as in a connected portion of the gap. This may be a fingerprint of the fact that the second electrically insulating layer structure may be the resin source for filling a corresponding other part of the gap. For example, the second electrically insulating layer structure may comprise fillers. For instance, said fillers may also be provided in the gap.

In an embodiment, the method comprises filling said at least part of said gap by curing the first resin and the second resin. Curing may be triggered in particular by the application of pressure and/or heat and/or UV (ultraviolet) light. Hence, the first resin and the second resin may be at least partially uncured before the gap between component and cavity sidewalls is filled with first resin and second resin. The first resin and the second resin may be cured after filling the gap between component and cavity sidewalls with first resin and second resin.

In the context of the present application, the term "uncured resin" may particularly denote at least partially uncured resin material, in particular a cross-linkable material (such as a resin which may experience cross-linking at elevated temperature and/or pressure) and/or a resin material which is capable of polymerizing. An uncured resin particularly denotes material which has the property to at least partially melt or become flowable by the application of elevated pressure and/or elevated temperature, and become fully hardened or cured (and thereby becomes permanently solid) when applying elevated pressure and/or temperature and/or UV light for a certain span of time.. Consequently, applying elevated pressure and/or elevated temperature may cause transformation of the curable or at least partially uncured resin into flowable material, for example by melting exceeding the glass transition temperature, followed by an irreversible hardening upon releasing the applied high pressure and/or high temperature. In particular, the at least partially uncured resin may comprise or consist of B-stage material and/or A-stage material. By providing the respective resin of B-stage material, it may re-melt during lamination and/or the material may fulfill a phase or state transformation so that the resin may flow for interconnecting the various elements and for closing gaps or voids and may therefore contribute to a stable intrinsic interconnection of a component to be embedded within the component carrier under manufacture. For example, curing agents may be added into liquid (for instance epoxy) resins in the A-stage and cured until a B-stage condition is reached. The B-stage may be a solid, thermoplastic stage. When given additional heat and/or pressure, the B-stage (for instance epoxy) resin may flow and continue to cure to a crosslinked condition or C-stage. In the C-stage, the resin may be fully cured and may permanently stay in a solid phase. For example the polymerization degree of an uncured resin may be between 0.1% and 85%, in particular between 25% and 70%.

In the context of the present application, the term "cured resin" may particularly denote a resin which has completed or completely undergone a curing process and is therefore incapable of being made flowable again, of polymerizing again and/or of cross-linking again. The cured resin may be in a cured irreversible hardened state. For example, cured resin may be in a C-stage. For example the polymerization degree of a cured resin may be at least 90%, in particular at least 95%.

In an embodiment, a first dielectric separation foil is provided on a main surface of the first electrically insulating layer structure facing away from the layer body and/or a second dielectric separation foil is provided on a main surface of the second electrically insulating layer structure facing away from the layer body. Said first dielectric separation foil may function as a barrier for the first resin for promoting directed first resin flow into the gaps, but not vertically beyond the limits defined by the first dielectric separation foil. Correspondingly, said second dielectric separation foil may function as a barrier for the second resin for promoting directed second resin flow into the gaps, but not vertically beyond the limits defined by the second dielectric separation foil.

In an embodiment, the method comprises removing the first dielectric separation foil from the main surface of the first electrically insulating layer structure and/or removing the second dielectric separation foil from the main surface of the second electrically insulating layer structure before completing manufacture of the component carrier. Thus, the dielectric separation foils may be temporary foils and may therefore not contribute to the thickness of the readily manufactured component carrier. For example, the method comprises completely removing said first dielectric separation foil and said second dielectric separation foil after curing the first resin and the second resin. After heating and/or pressurizing the first and second electrically insulating layer structures for curing and triggering resin flow into the gap between component and cavity sidewalls, the dielectric separation foils are no longer needed and can be removed for reducing the size of the readily manufactured component carrier.

In particular, the following is possible: The method comprises filling said at least part of said gap by curing the first resin and the second resin, in particular by the application of pressure and/or heat, and thereafter removing the first dielectric separation foil from the main surface of the first electrically insulating layer structure and/or removing the second dielectric separation foil from the main surface of the second electrically insulating layer structure before completing manufacture of the component carrier.

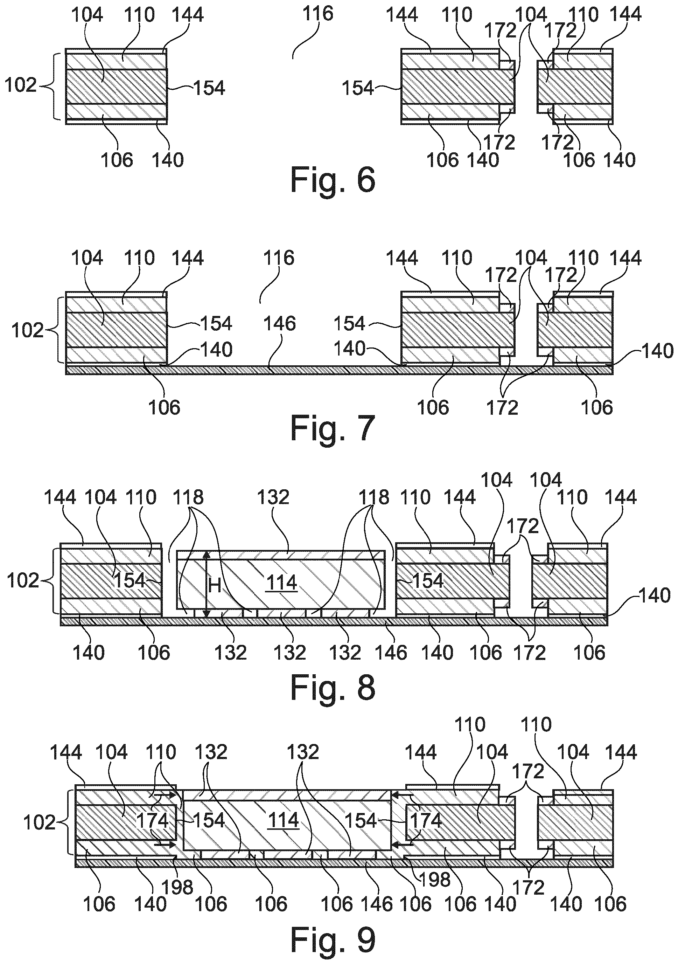

In an embodiment, a bottom side of the first electrically insulating layer structure has a step at a position corresponding to said sidewalls of the stack. Such a step, which is shown in Figure 9, may be the fingerprint of the use of temporary dielectric separation foils, which may be removed before completing manufacture of the component carrier.

In an embodiment, the (fiber-free) first electrically insulating layer structure and/or the (fiber-free) second electrically insulating layer structure may have a thermal conductivity bigger than 0.1 W/mK. This may bring the advantage that at least part of a heat, for example created by an electronic component, may be transmitted to a heat sink and/or the exposed surface via the fiber-free first electrically insulating layer structure and/or the fiber-free second electrically insulating layer structure resulting in a good and reliable heat management of the component carrier.

In an embodiment, the method comprising removing a portion of the layer body, a portion of the first electrically insulating layer structure, a portion of the second electrically insulating layer structure, a portion of the first dielectric separation foil and a portion of the second dielectric separation foil for forming said cavity. For example, cavity formation may be accomplished by laser cutting, mechanically cutting, routing or etching. For example, removing said portions may create a through hole-type cavity.

In an embodiment, the method comprises forming a fiducial mark in and/or on the layer body before arranging the first electrically insulating layer structure and the second electrically insulating layer structure on the layer body. Such a fiducial mark may for instance be a through hole extending through the stack, for example surrounded on one or both opposing ends thereof by an annular metal (for example copper) structure. Advantageously, such one or more fiducial marks may be used for alignment purposes, which may improve accuracy of the manufacturing process. The at least one fiducial mark may be removed before completing manufacture of the component carrier.

In an embodiment, the method comprises attaching a temporary carrier to the stack for closing the cavity prior to inserting the component into the cavity and on the temporary carrier. For instance, such a temporary carrier may be adhesive for temporarily adhering with the component(s) to be placed in the cavity for being subsequently embedded. For instance, the temporary carrier may be a sticky tape.

In an embodiment, the method comprises removing the temporary carrier after said curing. Hence, the temporary carrier may be removed from the component carrier because completing its manufacturing process. This may lead to a highly compact component carrier. Alternatively, the temporary carrier may form part of the readily manufactured component carrier.

In an embodiment, the method comprises arranging the first electrically insulating layer structure in an at least partially uncured state on the bottom main surface of the layer body, and arranging the second electrically insulating layer structure in an at least partially uncured state on the top main surface of the layer body, and subsequently filling said at least part of the gap by curing the first electrically insulating layer structure and by curing the second electrically insulating layer structure simultaneously. In particular, the curing process may be triggered by applying heat and/or mechanical pressure and/or UV light. By initiating curing, the first and/or second resin may be rendered flowable at the same time (or with a small degree of time shift), so that they may also flow in the gap between component and cavity sidewalls and may become connected with each other. During curing, the respective resin may polymerize and/or cross-link so as to become fully cured. The fully cured respective resin will then solidify for permanently holding the embedded component in the cavity.

The component may be embedded in a core-type layer body. In an alternative embodiment, the component may be embedded in a coreless component carrier.

In an embodiment, at least part of the component is directly surrounded by the first resin, the second resin, and optionally at least one of the first and/or second electrically insulating layer structures. Any of the aforementioned dielectric constituents may be functionalized as buffer structure for buffering stress. Preferably, the buffer structure comprises or consists of a material which has a value of the Young modulus below 25 GPa, in particular below 10 GPa, more particularly below 5 GPa. Such a material may serve as a mechanical buffer structure, i.e. as a mechanically relatively flexible or elastic electrically insulating structure. This may render said material highly appropriate for (in particular directly) surrounding an embedded component of the component carrier. Such a mechanical buffer structure may have a locally reduced value of the Young modulus and may therefore function as a mechanically damping or force balancing structure, for instance in the event of thermal stress. Thus, excellent results may be achieved when embedding the component in a low Young modulus dielectric. The dielectric buffer structure may have a lower value of the Young modulus than any other dielectric material of the component carrier.

In the following, different embedding technologies which may be used according to exemplary embodiments for embedding the component in the layer body will be explained:
In an embodiment, the method of manufacturing the component carrier comprises embedding the component in a cavity of the layer body (in particular layer stack), wherein the cavity is at least temporarily closed at a bottom side by a sticky layer during the embedding. In the context of the present application, the term "sticky layer" may particularly denote a tape, film, foil, sheet or plate having an adhesive surface. In use, the sticky layer may be used to be adhered to a main surface of a layer body for closing an opening extending through the layer body. The component to be embedded may be adhered to the sticky layer for defining a position of the component in the opening and thus relative to the layer body with the two electrically insulating layer structures attached to the two opposing main surfaces thereof. When the sticky layer is removed from the layer body with the two attached electrically insulating layer structures before completing manufacture of the component carrier, the sticky layer may be denoted as a temporary carrier. In other embodiments, the sticky layer may however form part of the readily manufactured component carrier. By adhering the component on the sticky tape during the embedding process, the spatial accuracy of the embedding of the component may be significantly improved.

In another embodiment, the method comprises mounting the component on at least one layer structure or on a temporary carrier, and thereafter covering the component with the layer body or with further layer structures, wherein the layer body is provided with an opening accommodating the component. For example, the opening of layer body may be cut as a through hole into the layer body. Further alternatively, it is also possible to cover the component, attached to a temporary carrier or to one or more layer structures, with a flowable medium, such as resin, which may form the layer body.

In yet another embodiment, the method comprises embedding a release layer in the stack, thereafter forming an opening (such as a blind hole) in the stack by removing a piece of the stack which is delimited at a bottom side by the release layer, and thereafter accommodating the component in the opening, i.e. in a portion of the remaining stack forming the layer body. For instance, such a release layer may be made of a material showing poorly adhesive properties with respect to surrounding layer body material. For instance, an appropriate material for the release layer is polytetrafluoroethylene (PTFE, Teflon), or a waxy compound. The method may comprise forming a circumferential cutting trench in the layer body section of the stack extending up to the release layer to thereby separate the piece from a rest of the stack with its layer body portion. Cutting said trench may be accomplished for example by laser drilling or mechanically drilling.

In another embodiment, the method comprises forming an opening (such as a blind hole) in the stack by routing (preferably depth routing), and thereafter accommodating the component on a bottom surface of the routed stack in the opening. Routing is an appropriate and simple mechanism of precisely defining a blind hole-type opening for subsequently accommodating the component. The routed portion of the stack may form the layer body.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2 to Figure 13 illustrate cross-sectional views of structures obtained during carrying out a method of manufacturing a component carrier, shown in Figure 1, according to an exemplary embodiment of the invention.
Figure 14 and Figure 15 illustrate cross-sectional views of structures obtained during carrying out a method of manufacturing a component carrier according to another exemplary embodiment of the invention.
Figure 16 illustrates a cross-sectional view of a structure obtained during carrying out a method of manufacturing a component carrier according to still another exemplary embodiment of the invention.
Figure 17 illustrates a cross-sectional view of a structure obtained during carrying out a method of manufacturing a component carrier according to yet another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, a component carrier (like a PCB or an IC substrate) is provided based on a layer stack, which may be formed by lamination. Said stack may comprise in its middle a layer body (such as a core). Optionally, at least part of the layer body may comprise a glass and/or a ceramic plate structure, in particular at least portions of the core may comprise a glass and/or a ceramic plate structure. The latter can be arranged above a fiber-free first electrically insulating layer structure on the bottom side which may have a first resin but no fibers and below a fiber-free second electrically insulating layer structure on the top side which may have a second resin (which may be made of the same material as or of another material than the first resin) but also no fibers. Optionally, the fiber-free first electrically insulating layer structure may be different from the fiber-free second electrically insulating layer structure by the material and/or the size and/or the shape and/or the amount of filler material and/or filler particles even if the material of the first resin of the fiber-free first electrically insulating layer structure and the material of the second resin of the fiber-free second electrically insulating layer structure is the same. One or more electronic components may be encapsulated within one or more recesses of the stack. The at least one recess or the at least one cavity comprises two opposed-located sidewalls. A first portion (in particular a bottom portion) of a lateral gap between electronic component and cavity sidewalls is filled with the first resin from the fiber-free first electrically insulating layer structure, whereas a second portion (in particular a top portion) of said lateral gap is filled with the second resin from the fiber-free second electrically insulating layer structure. This may allow to reliably fix in place the electronic component in the cavity, wherein a symmetric resin flow may occur from two vertically opposing sides into the above-mentioned gap which also may lead to very thin and compact component carriers. Furthermore, this compactness in combination with the opportunity to directly electrically connect the embedded electronic component may lead to short signal paths, and consequently to low losses and high signal integrity. Beyond this, the symmetric stack design may suppress warpage.

More specifically, an exemplary embodiment of the invention may provide an embedding technology which is appropriate also for double sided component connection. Advantageously, component fixation may be accomplished with a simultaneous resin flow at a bottom side and at a top side of the component in a horizontal flow direction, wherein said resin flow is then redirected into a gap between component and stack. When executing the manufacturing architecture of exemplary embodiments of the invention, very thin packages can be realized. Descriptively speaking, the thickness of the package-type component carrier may be approximately the thickness of the embedded electronic component plus the thicknesses of the fiber-free resin layers. In a further example, the thickness of the package-type component carrier may be bigger in stack thickness direction than the embedded electronic component plus the thicknesses of the fiber-free resin layers, since additionally electrically conductive layer structures and/or electrically insulating layer structures are included. Advantageously, there are essentially no limitations in term of component metallization. Apart from this, very short signal paths may be achieved due to the possibility of a direct component connection. For instance, an electrically conductive material (such as copper) may be directly deposited (for instance sputtered) onto exposed component pads to thereby achieve the mentioned short signal paths. Advantageously, no warpage issues may occur due to a symmetric stack-up. In addition, the effort for manufacturing component carriers according to exemplary embodiments of the invention may be reasonably low.

According to an exemplary embodiment of the invention, a manufacturing architecture with a process flow is provided which allows for a double sided direct fan out packaging. Advantageously, this may allow to properly fix the embedded component with a horizontal resin flow both from the top side and from the bottom side. For instance, the component may be embedded by semi-cured Ajinomoto Build-Up Film ^{®} (ABF) materials. Very thin packages can be produced due to availability of ABF in several thicknesses. Also compliance with registration design rules may be achieved. A small gap near the filled cavity may be obtained on a back side from a height difference of a liner foil, which may be used.

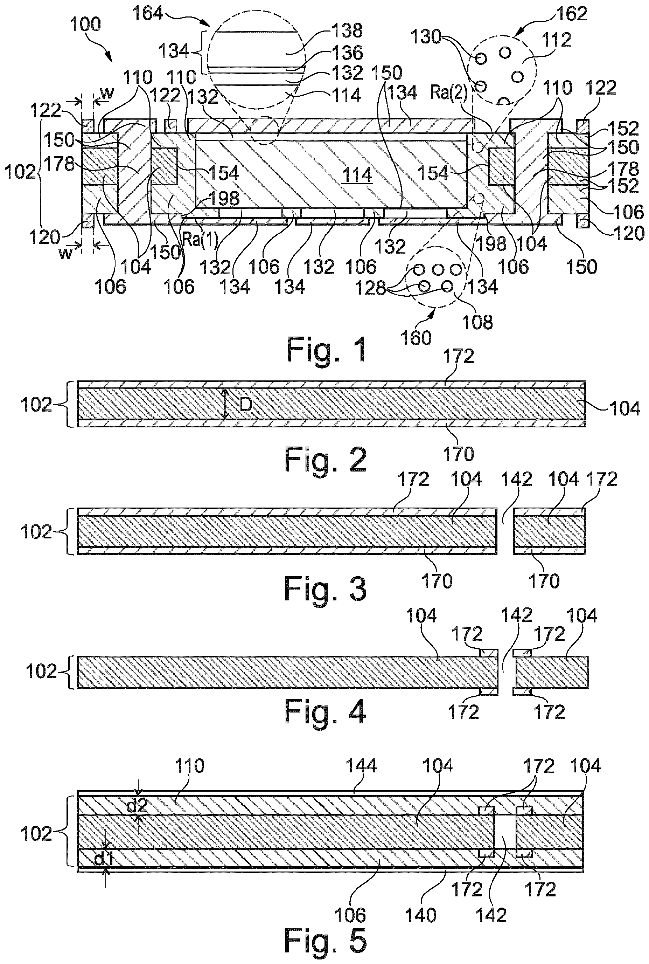

**Figure 1** illustrates a cross-sectional view of a component carrier 100 according to an exemplary embodiment of the invention. In the shown embodiment, component carrier 100 is embodied as a printed circuit board (PCB). However, component carrier 100 may also be an integrated circuit (IC) substrate, etc.

Component carrier 100 according to Figure 1 may be configured as a substantially plate-shaped printed circuit board (PCB). Thus, the component carrier 100 shown in Figure 1 may be highly compact in a vertical direction. More specifically, the component carrier 100 may comprise a stack 102 comprising one or more electrically conductive layer structures 150 and/or one or more electrically insulating layer structures 152. The electrically conductive layer structures 150 may comprise a horizontal wiring structure (for example with traces and pads) and vertical through connections, for example copper filled vias or copper filled through holes which may be created by mechanical drilling or laser drilling and plating. A part of the electrically insulating layer structures 152, in particular a central layer body 104 thereof, may comprise a respective resin (such as a respective epoxy resin), preferably comprising reinforcing fibers therein (for instance glass fibers). For instance, the central layer body 104 may be made of FR4. In another example, at least a portion of the layer body may comprise a glass and/or a ceramic plate structure, in particular at least portions of the core may comprise a glass and/or a ceramic plate structure. Other electrically insulating layer structures 152, in particular first electrically insulating layer structure 106 and second electrically insulating layer structure 110, may be free of fibers and may comprise for instance resin 108, 112 and optionally filler particles 128, 130.

In the illustrated embodiment, the stack 102 comprises a layer body 104 of fully cured FR4 material and vertical through connections 178 made of copper and optionally other metals, for example palladium, and extending vertically through the layer body 104. The layer body 104 may be a core with a fully cured resin.

Furthermore, the component carrier 100 comprises an electronic component 114 (or any other component, such as a non-electronic component, for instance a copper block or a ceramic clock) which is at least partially, preferably completely, embedded in the stack 102. For example, component 114 may be an active electronic component, such as a semiconductor chip (for example a silicon chip). For example, electronic component 114 may be configured for a power application and/or a high-frequency application. In the shown embodiment, component 114 has three metallic pads 132 on a lower main surface and one metallic pad 132 on an upper main surface.

More specifically, the illustrated component carrier 100 comprises stack 102 having central layer body 104, fiber-free first electrically insulating layer structure 106 including first resin 108 on a bottom main surface on the layer body 104, and fiber-free second electrically insulating layer structure 110 including second resin 112 on a top main surface of the layer body 104. The electronic component 114 is inserted and embedded in a cavity (see reference sign 116 in Figure 6) of the stack 102. As shown, a part of a gap (see reference sign 118 in Figure 8) between the electronic component 114 and sidewalls 154 of the stack 102 delimiting the cavity 116 is filled partially with the first resin 108 and partially with the second resin 112. More specifically, a bottom portion of said gap 118 may be filled with the first resin 108, whereas a top portion of said gap 118 may be filled by said second resin 112. Optionally, a bottom portion of said gap 118 may be filled by said second resin 112 and/or a top portion of said gap 118 may be filled by said first resin 108. Either a discontinuous interface may be formed between the first resin 108 and the second resin 112, or an intermingling region comprising a resin mixture of first resin 108 and second resin 112 may be formed between a region of pure first resin 108 and a region of pure second resin 112. This may be adjusted by the selection of the resin materials and the processing conditions during manufacture of component carrier 100.

As shown in details 160, 162 of Figure 1, each of the first resin 108 and the second resin 112 may comprise respective filler particles 128, 130, which may be different or the same. By said filler particles 128, 130, an additional functionality may be added to the respective resin 108 or 112, such as an enhancement of thermal conductivity, an electromagnetic shielding function, a preferred flow behaviour, etc. For promoting a symmetric stack-up, the first electrically insulating layer structure 106 and the second electrically insulating layer structure 110 may be made of the same material, i.e. may comprise the same resin material for resins 108, 112 and the same filler material for the filler particles 128, 130. This may suppress artefacts such as warpage and delamination of component carrier 100. Alternatively, different resin materials and/or different filler particle materials may be used for the electrically insulating layer structures 106, 110, which may allow to adjust in a spatially dependent manner the properties of the dielectric surrounding of the electronic component 114.

For example, a major portion of the electronic component 114 may be directly surrounded by the first resin 108 and the second resin 112 which may be embodied as dielectric buffer structure for buffering stress. Preferably, said buffer structure is constituted by the resin material of resins 108, 112 which may both have a value of the Young modulus below 8 GPa, in particular below 3 GPa, more particularly below 1 GPa. Such a dielectric resin material may serve as a flexible or elastic electrically insulating surrounding of the embedded electronic component 114 and may reliably protect the latter against stress during operation of the component carrier 100. In a further example, the fiber-free first electrically insulating layer structure and/or the fiber-free second electrically insulating layer structure may have a thermal conductivity bigger than 0.1 W/mK. This may bring the advantage that at least part of a heat, for example created by an electronic component, may be transmitted to a heat sink and/or the exposed surface via the fiber-free first electrically insulating layer structure and/or the fiber-free second electrically insulating layer structure resulting in a good and reliable heat management of the component carrier.

Advantageously, a material composition of the first electrically insulating layer structure 106 on the layer body 104 and on the electronic component 114 may be the same as in a connected lower portion of the gap 118 between electronic component 114 and cavity-delimiting sidewalls 154 of the stack 102. Correspondingly, a material composition of the second electrically insulating layer structure 110 on the layer body 104 and on the electronic component 114 may be the same as in a connected upper portion of the gap 118 between electronic component 114 and cavity-delimiting sidewalls 154 of the stack 102. This may lead to a symmetric stack-up and thus a high reliability of the component carrier 100.

Advantageously, the first electrically insulating layer structure 106 has a very low roughness Ra preferably in a range from 20 nm to 400 nm on a main surface facing away from the layer body 104, i.e. on a lower main surface, see reference sign Ra(1) in Figure 1. Correspondingly, the second electrically insulating layer structure 110 may also have a very low roughness Ra preferably in a range from 20 nm to 400 nm on a main surface facing away from the layer body 104, i.e. on an upper main surface, see reference sign Ra(2) in Figure 1. One reason for said very low roughness is the fact that the electrically insulating layer structures 106, 110 are made of pure resin 108, 112 with filler particles 128, 130, respectively, but without reinforcing glass fibers. This very low roughness makes it possible to form a first electrically conductive fine line pattern 120 directly on the extremely smooth main surface of the first electrically insulating layer structure 106 facing away from the layer body 104. Correspondingly, this enables formation of a second electrically conductive fine line pattern 122 directly on the extremely smooth main surface of the second electrically insulating layer structure 110 facing away from the layer body 104. In view of said high smoothness, the first fine line pattern 120 and the second fine line pattern 122 may each comprise electrically conductive traces and/or stack pads or lands having a width w in a range from 2 µm to 15 µm. More specifically, the first fine line pattern 120 may be formed directly on the smooth surface of the first electrically insulating layer structure 106 and on one or more pads 132 (three in the shown embodiment) at a lower main surface of the electronic component 114, preferably by sputtering. In a corresponding way, the second fine line pattern 122 may be formed directly on the smooth surface of the second electrically insulating layer structure 110 and on one or more pads 132 (one in the shown embodiment) and at an upper main surface of the electronic component 114, preferably by sputtering. Thus, an upper and a lower electrically conductive sputtering layer 134 may be formed directly on the respective electrically conductive pad(s) 132 of the electronic component 114 and may be formed directly on exposed portions of the first electrically insulating layer structure 106 and of the second electrically insulating layer structure 110. The electrically conductive sputtering layers 134 may form the respective fine line patterning 120, 122 for trace formation with highest integration density and may accomplish the electric contacting of the component pads 132. All this can be achieved with highest accuracy, highest density and lowest dimensions. Furthermore, this direct electric contacting architecture may lead to a very small thickness of the obtained component carrier 100 in vertical direction, which is basically only defined by the height of the component 114, the height of the electrically insulating layer structures 106, 110 and the height of the sputtering layers 134.

As can be taken from a detail 164 of Figure 1, the sputtering layer 134 may comprise an adhesion promoter sublayer 136, which may promote adhesion of the sputtering layer 134 on the respective electrically insulating layer structure 106, 110 and on the pads 132. The adhesion promoter sublayer 136 may be preferably electrically conductive. Furthermore, a metallic layer 138 may be formed on the adhesion promoter sublayer 136 and may function as the actual electric signal transport structure.

Due to the manufacturing process of the component carrier 100 (see Figure 2 to Figure 13), the electrically conductive pads 132 of the electronic component 114 may be made of any desired metallic or alloy material, and may be made in particular also from another material than copper. This freedom of design results from the formation of the sputtering layers 134 directly on the electrically insulating layer structures 106, 110 and the pads 132.

Figure 2 to Figure 13 illustrate cross-sectional views of structures obtained during carrying out a method of manufacturing a component carrier 100, shown in Figure 1, according to an exemplary embodiment of the invention.

Referring to **Figure 2**, an initial stack 102 is provided which is composed of a central layer body 104, a first metal layer 170 on a lower main surface thereof and a second metal layer 172 on an upper main surface thereof. The central layer body 104 may be made of a fully cured core, for instance comprising cured resin (such as epoxy resin) and reinforcing fibers (such as glass fibers), optionally comprising filler particles (such as ceramic filler particles, for instance made of silicon oxide). For instance, such a core may be made of FR4 material. A vertical thickness, D, of the central layer body 104 may be preferably in a range from 40 µm to 80 µm. Alternatively, a vertical thickness, D, of the central layer body 104 may be preferably in a range from 15 µm to 300 µm. For example, the first metal layer 170 and the second metal layer 172 may be copper foils. To put it shortly, the layer structure of Figure 2 may be a copper clad core.

Referring to **Figure 3****,** it may be possible to form a fiducial mark 142 in the layer body 104 and the metal layers 170, 172. In the shown embodiment, fiducial mark 142 is formed by creating a through hole extending vertically through the entire layer structure shown in Figure 2. For instance, this may be accomplished by mechanically drilling using a frame drill.

Referring to **Figure 4****,** metal layers 170, 172 may then be patterned so as to remove the entire metallic material from layer body 104 apart from a direct surrounding of the through hole forming the fiducial mark 142. This may be done by a photo process and etching process.

Referring to **Figure 5****,** processing of stack 102 may continue with arranging a fiber-free first electrically insulating layer structure 106 including a first resin 108 (and optionally filler particles 128, see Figure 1) on a bottom main surface of a layer body 104. Furthermore, a fiber-free second electrically insulating layer structure 110 including a second resin 112 (and optionally filler particles 130, see Figure 1) may be arranged on a top main surface of the layer body 104. For example, the electrically insulating layer structures 106, 110 may be ABF sheets remaining at least partially uncured while being laminated to the layer body 104, i.e. being still uncured in the condition of Figure 5. Advantageously, both at least partially uncured electrically insulating layer structures 106, 110 may be connected with layer body 104 simultaneously. For example, said connection may be accomplished by lamination, i.e. the supply of heat and/or pressure, however only to such a degree that the electrically insulating layer structures 106, 110, in a state in which they are already connected with layer body 104, are still at least partially uncured. Advantageously, this may allow to subsequently render the resins 108, 112 of the electrically insulating layer structures 106, 110 flowable again in a further lamination process described below referring to Figure 9, thereby making it possible to fill gaps 118 with the resins 108, 112. Only after said subsequent further lamination process, the resins 108, 112 may become fully cured by being permanently solidified. Thus, the first electrically insulating layer structure 106 may be attached in an at least partially uncured state on the bottom main surface of the layer body 104, and the second electrically insulating layer structure 110 may be attached in an at least partially uncured state on the top main surface of the layer body 104.

As shown in Figure 5, a respective thickness d1, d2 of each of the first electrically insulating layer structure 106 and the second electrically insulating layer structure 110 may be preferably in a range from 15 µm to 20 µm. Alternatively, a respective thickness d1, d2 of each of the first electrically insulating layer structure 106 and the second electrically insulating layer structure 110 may be in a range from 5 µm to 50 µm. In a further example, a respective thickness d1, d2 of each of the first electrically insulating layer structure 106 and the second electrically insulating layer structure 110 may be bigger than 50 µm, but still smaller than 500 µm. Advantageously, both thicknesses d1, d2 may be the same for achieving a symmetrical stack-up and thereby suppressing undesired warpage. With the mentioned small thicknesses, a very thin component carrier 100 may be obtained.

Moreover, a first dielectric separation foil 140 may be provided on a main surface of the first electrically insulating layer structure 106 facing away from the layer body 104. At the same time as the first dielectric separation foil 140, a second dielectric separation foil 144 may be provided on a main surface of the second electrically insulating layer structure 110 facing away from the layer body 104. For example, the dielectric separation foils 140, 144 may be made of a plastic material, for example polyethylene terephthalate (PET). The dielectric separation foils 140, 144 may provide for an exterior separation of the resins 108, 112 of the dielectric layer structures 106, 110 during a further subsequent lamination process described below referring to Figure 9. As can be seen, at least a portion of the fiducial mark 142 is free from first electrically insulating layer structure 106 and the second electrically insulating layer structure 110.

Referring to **Figure 6****,** a cavity 116 is formed in the stack 102. More precisely, a through hole is formed which constitutes said cavity 116. In order to form said cavity 116, a portion of the layer body 104, a portion of the first electrically insulating layer structure 106, a portion of the second electrically insulating layer structure 110, a portion of the first dielectric separation foil 142 and a portion of the second dielectric separation foil 144 are removed. For instance, this can be accomplished by laser cutting. To put it shortly, Figure 6 illustrates a process involving skiving for cavity creation. The cavity 116 comprises two opposed located sidewalls 154, which have essentially vertically straight directions. Alternatively, the cavity 116 may have inclined sidewalls 154.

Referring to **Figure 7****,** a temporary carrier 146 is attached to the bottom side of the stack 102 for closing the cavity 116 at a bottom side. For example, temporary carrier 140 is a sticky tape. For instance, temporary carrier 146 may be laminated on the stack 102.

Referring to **Figure 8****,** an electronic component 114 is inserted in the cavity 116 of the stack 102 and is temporarily attached in an adhering fashion on the adhesive surface of the temporary carrier 140. Alternatively, a plurality of components 114 may be inserted in the cavity 116 of the stack 102. This mentioned inserting process may ensure that the electronic component 114 to be embedded is temporarily fixed in place in the cavity 116. A permanent fixation of electronic component 114 is accomplished later on by curing the resins 108, 112 so that they flow in gaps 118 and glue the electronic component 114 in place.

In the illustrated embodiment, the electronic component 114 comprises electrically conductive pads 132 both on a bottom main surface and on a top main surface thereof. Alternatively, the component 114 comprises at least one electrically conductive pad 132 on either, a bottom main surface or on a top main surface. For example, the electronic component 114 may be a semiconductor die, for example for radio frequency applications or as a control chip.

For example, a vertical thickness H of the electronic component 114 may be 60 µm, more generally may be in a range from 30 µm to 100 µm. Preferably, an overall thickness of the layer body 104 and the layer structures 106 and 110 together may be not more than 10 µm, preferably not more than 5 µm, larger than the thickness H of the electronic component 114. Hence, ultra-thin component carriers 100 may be manufactured with the described manufacturing architecture.

Referring to **Figure 9****,** a gap 118 between the electronic component 114 and sidewalls 154 of the stack 102 delimiting the cavity 116 is filled partially with the first resin 108 and partially with the second resin 112. This is accomplished by the application of pressure and/or heat to the structure of Figure 8 for curing the first resin 108 and the second resin 112 of the electrically insulating layer structures 106, 110 by a single common process. By the application of pressure and/or heat, the at least partially uncured resins 108, 112 will become flowable, and will start curing (in particular by polymerizing and/or forming cross-links). At least a portion of the material, preferably the entire material, which is filling the gap 118 is free from glass fibers and/or may originate from material of the first resin 108 and material of the second resin 112. Upon completion of the curing process, the now cured resins 108, 112 will become permanently solid and will glue in place the embedded electronic component 114. During the curing process, a horizontal resin flow occurs at the same time below and above the component 114, as indicated by arrows 174 in Figure 9. Said double resin flow will then be redirected into gap 118 due to the shown geometry. The horizontal resin flow will be promoted by the dielectric separation foils 140, 144 rendering impossible a resin flow in a vertical direction before reaching gap 118. Filling said gap 118 may be accomplished by curing the first electrically insulating layer structure 106 and by curing the second electrically insulating layer structure 110 simultaneously, i.e. during a single common process. When flowing into gap 118, resins 108, 112 will flow in opposite directions and/or equal direction and will form a common interface in the gap 118 between the two opposing main surfaces of the embedded electronic component 114. It may be possible that the first resin 108 and the second resin 112 have different viscosities and/or flow behaviour. Thereby, the respective resin having a lower viscosity compared to the other of the respective resins may fill up cores and/edges inside the cavity 116. This may lead to a void or bubble free structure. As can be seen in Figure 9, the presence of the dielectric separation foils 140, 144 leads to the formation of a circumferential step 198 at a bottom side of the first electrically insulating layer structure 106 at a position corresponding to said sidewalls 154 of the stack 102.

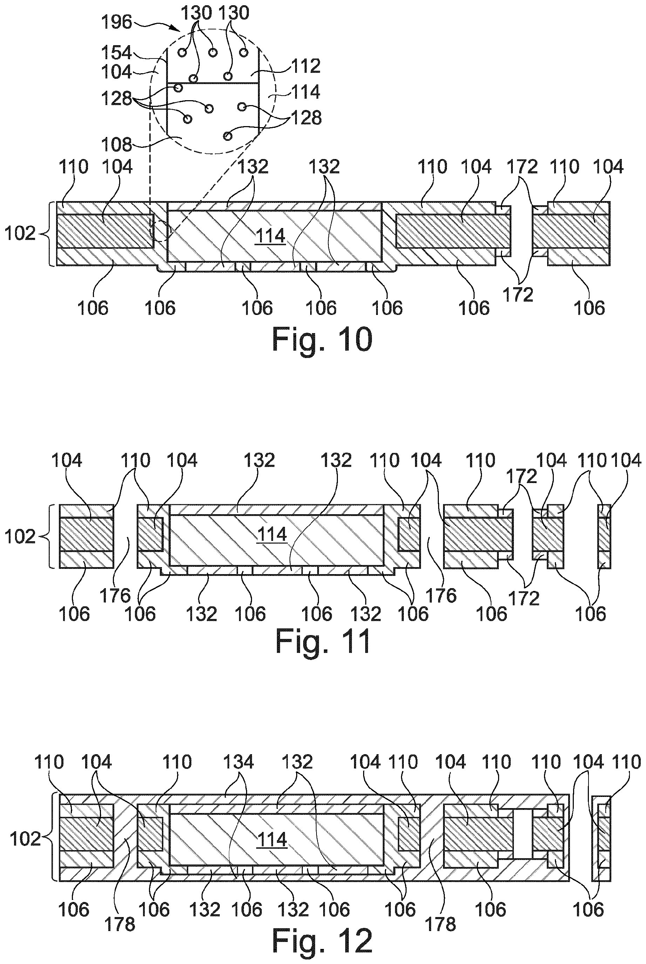

Referring to **Figure 10****,** a detail 196 shows the material distribution within gap 118. As shown, the lower portion of the gap 118 is filled with first resin 108 (and optionally first filler particles 128) of first electrically insulating layer structure 106, whereas the upper portion of the gap 118 is filled with second resin 112 (and optionally second filler particles 130) of second electrically insulating layer structure 110. In between the first resin 108 and the second resin 112, an interface may form, which could be detected by analytical measurements, for example microscopy.

According to Figure 10, the temporary carrier 146 may be removed from the stack 102 after said curing. Thereafter, the remaining portion of the first dielectric separation foil 140 may be removed from the main surface of the first electrically insulating layer structure 106 after said curing. Furthermore, the remaining portion of the second dielectric separation foil 144 may be removed from the main surface of the second electrically insulating layer structure 110 after said curing.

Referring to **Figure 11****,** vertical through holes 176 may be formed in the layer structure obtained according to Figure 10. For example, this may be accomplished by laser drilling or mechanical drilling.

Referring to **Figure 12****,** electrically conductive material may be deposited on the exposed surfaces of the structure of Figure 11. For example, this may be done by plating (for instance electroless plating followed by electroplating) and/or physical vapor deposition (PVD) or sputtering. As a result, an electrically conductive sputtering layer 134 is formed directly on the pads 132 on both main surfaces of the electronic component 114, directly on the lower main surface of the electrically insulating layer structure 106, and directly on the upper main surface of the second electrically insulating layer structure 110. Furthermore, sputtered electrically conductive material may fill the holes 176 to thereby form vertical through connections 178 for electrically coupling the opposing main surfaces of the stack 102.

As a support for the sputtering layer 134, an adhesion promoter sublayer (not shown in Figure 12, compare reference sign 136 in Figure 1) may be formed before depositing metal, which may promote adhesion of the sputtering layer 134 on the respective electrically insulating layer structure 106, 110 and on the pads 132.

Advantageously, the exposed pads 132 on both opposing main surfaces of the electronic component 114 may be directly electrically connected over their full extension with the electrically conductive sputtering layer 134 without the need of drilling laser vias before sputtering. This leads to a compact design, short electric paths, low electric losses, and low dissipation of heat.

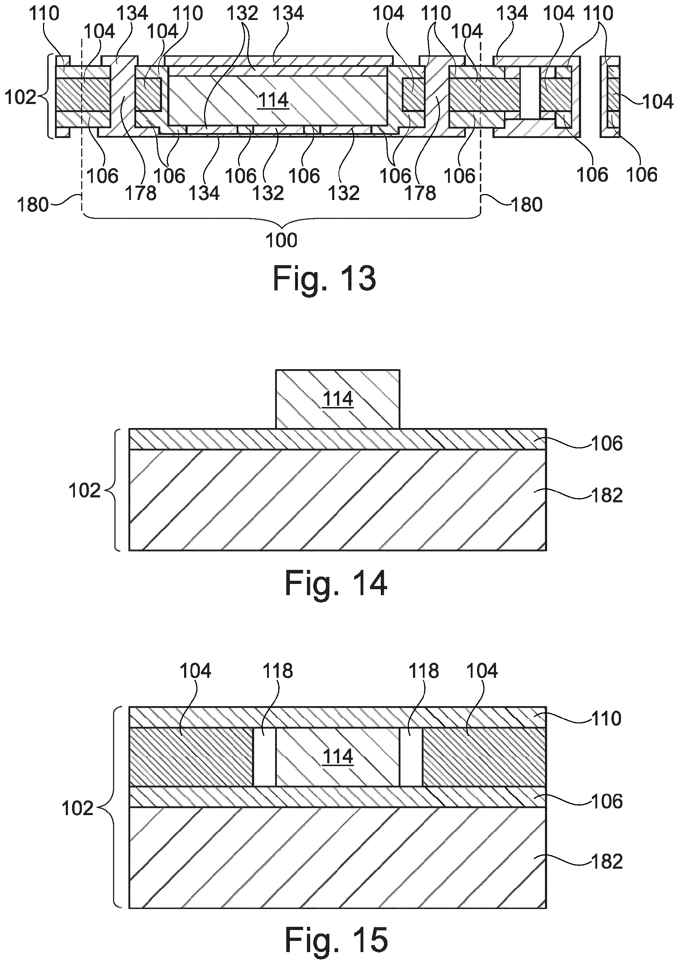

Referring to **Figure 13****,** the electrically conductive sputtering layer 134 on both opposing main surfaces of the obtained component carrier 100 may be patterned for forming a wiring pattern which may comprise electrically conductive traces and metallic pads or lands. For instance, said patterning may be executed by a photo process. More specifically, it may be possible to accomplish said patterning by a lithography and etching process. In view of the pronounced smoothness or low roughness Ra of the exposed lower main surface of the first electrically insulating layer structure 106 (being free of fibers) and the exposed upper main surface of the second electrically insulating layer structure 110 (being free of fibers), said wiring pattern may be formed with high integration density and small dimensions.

Although not shown, individual component carriers 100 may be separated from the processed panel by separating the processed panel along separation lines 178. For instance, said separation may be done by laser cutting or mechanically cutting. As a result, component carriers 100 according to Figure 1 may be obtained.

Figure 14 and Figure 15 illustrate cross-sectional views of structures obtained during carrying out a method of manufacturing a component carrier 100 according to another exemplary embodiment of the invention.

Referring to **Figure 14****,** the electronic component 114 is mounted on first electrically insulating layer structure 106 comprising at least partially uncured material and being arranged on a support body 182 (for instance a laminated arrangement of one or more electrically conductive layer structures and/or one or more electrically insulating layer structures) of stack 102.

Referring to **Figure 15****,** the structure according to Figure 14 is covered with a layer body 104 having a through hole defining cavity 116 so that the electronic component 114 is arranged inside of the cavity 116 with a gap 118 in between. On top of the obtained structure, a full layer in form of the second electrically insulating layer structure 110 comprising at least partially uncured material is placed so as to cover the upper main surface of the layer body 104 and the upper main surface of the electronic component 114.

Although not shown, initially uncured electrically insulating layer structures 106, 110 may then be fully cured so that first and second resins 108, 112 fill the gap 118.

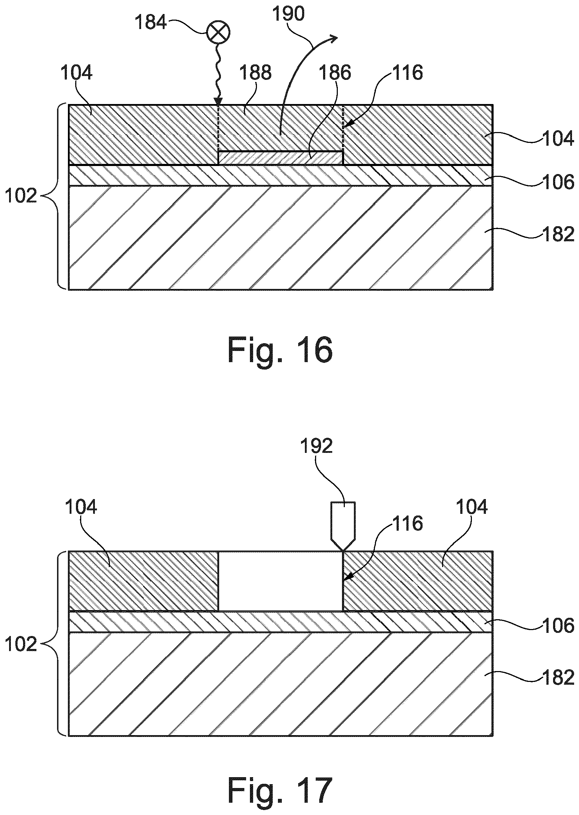

**Figure 16** illustrates a cross-sectional view of a structure obtained during carrying out a method of manufacturing a component carrier 100 according to still another exemplary embodiment of the invention.

According to Figure 16, a stack 102 is provided which comprises a support body 182 (which can be embodied as according to Figure 14), the at least partially uncured first electrically insulating layer structure 106 thereon, and layer body 104 on the first electrically insulating layer structure 106. Furthermore, a release layer 186 may be formed at an interface between the first electrically insulating layer structure 106 and the layer body 104. For instance, such a release layer 186 may be made of a material showing poorly adhesive properties with respect to surrounding material. For instance, an appropriate material for the release layer 186 is polytetrafluoroethylene (PTFE, Teflon), or a waxy compound. Thereafter, a cavity 116 is formed in the layer body 104 by removing (see reference sign 190) a piece 188 of the layer body 104 which is delimited at a bottom side by the release layer 186. For separating piece 188 along a circumferential direction, it may be possible to form a circumferential cutting trench in the layer body 104 extending up to the release layer 186 to thereby separate the piece 188 from a rest of the layer body 104. Cutting said trench may be accomplished for example by laser drilling using a laser source 184, or by mechanically drilling. The cavity 116 according to Figure 16 may comprise vertically straight or vertically inclined sidewalls 154.

After taking out piece 188, the release layer 186 may be removed (for instance by stripping), and an electronic component 114 may be placed subsequently in the obtained cavity 116 on an exposed portion of the at least partially uncured first electrically insulating layer structure 106. Partially uncured second electrically insulating layer structure 110 may then be placed on top of the layer body 104 and of the electronic component 114, so that a structure corresponding to Figure 15 is obtained. The further processing may then be as explained above referring to Figure 15.

**Figure 17** illustrates a cross-sectional view of a structure obtained during carrying out a method of manufacturing a component carrier 100 according to yet another exemplary embodiment of the invention.

The embodiment according to Figure 17 differs from the embodiment according to Figure 16 in particular in that, according to Figure 17, no release layer 186 and no laser cutting are used, but in contrast to this a routing machine 192 is used for routing cavity 116 in layer body 104.

Thereafter, an electronic component 114 may be placed in the obtained cavity 116 on an exposed portion of the at least partially uncured first electrically insulating layer structure 106. Partially uncured second electrically insulating layer structure 110 may then be placed on top of the layer body 104 and of the electronic component 114, so that a structure corresponding to Figure 15 is obtained. The further processing may then be as explained above referring to Figure 15.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A component carrier (100), wherein the component carrier (100) comprises:
a stack (102) comprising a layer body (104), a fiber-free first electrically insulating layer structure (106) including a first resin (108) on a bottom main surface on the layer body (104), and a fiber-free second electrically insulating layer structure (110) including a second resin (112) on a top main surface of the layer body (104); and
a component (114) inserted in a cavity (116) of the stack (102);
wherein at least part of a gap (118) between the component (114) and sidewalls (154) of the stack (102) delimiting the cavity (116) is filled partially with the first resin (108) and partially with the second resin (112).

2. The component carrier (100) according to claim 1, wherein the first electrically insulating layer structure (106) has a roughness Ra in a range from 10 nm to 800 nm, in particular in a range from 20 nm to 400 nm, on a main surface facing away from the layer body (104), and/or wherein the second electrically insulating layer structure (110) has a roughness Ra in a range from 10 nm to 800 nm, in particular in a range from 20 nm to 400 nm, on a main surface facing away from the layer body (104).

3. The component carrier (100) according to any of claims 1 to 2, comprising a first electrically conductive fine line pattern (120) on a main surface of the first electrically insulating layer structure (106) facing away from the layer body (104), and/or comprising a second electrically conductive fine line pattern (122) on a main surface of the second electrically insulating layer structure (110) facing away from the layer body (104), wherein in particular the first fine line pattern (120) and/or the second fine line pattern (122) comprises an electrically conductive trace having a width (w) in a range from 1 µm to 15 µm.

4. The component carrier (100) according to any of claims 1 to 3, wherein the first electrically insulating layer structure (106) includes first filler particles (128), and/or wherein the second electrically insulating layer structure (110) includes second filler particles (130).

5. The component carrier (100) according to any of claims 1 to 4, comprising an electrically conductive layer, for example a sputtering layer (134), formed directly on at least one electrically conductive pad (132) of the component (114) and/or formed directly on at least one of the first electrically insulating layer structure (106) and the second electrically insulating layer structure (110).

6. The component carrier (100) according to any of claims 1 to 5, wherein a thickness (d1, d2) of at least one of the first electrically insulating layer structure (106) and the second electrically insulating layer structure (110) is in a range from 5 µm to 100 µm, for example in a range from 10 µm to 50 µm.

7. The component carrier (100) according to any of claims 1 to 6, wherein a thickness (D) of the layer body (104) is in a range from 15 µm to 500 µm, in particular in a range from 20 µm to 100 µm.

8. The component carrier (100) according to any of claims 1 to 7, wherein the first electrically insulating layer structure (106) and the second electrically insulating layer structure (110) are made of the same material.

9. The component carrier (100) according to any of claims 1 to 8, wherein a material composition of the first electrically insulating layer structure (106) on the layer body (104) and on the component (114) is the same as in a connected portion of the gap (118), and/or wherein a material composition of the second electrically insulating layer structure (110) on the layer body (104) and on the component (114) is the same as in a connected portion of the gap (118).

10. The component carrier (100) according to any of claims 1 to 9, comprising at least one of the following features:
wherein a bottom side of the first electrically insulating layer structure (106) has a step (198) at a position corresponding to said sidewalls (154) of the stack (102).

11. A method of manufacturing a component carrier (100), wherein the method comprises:
forming a stack (102) by arranging a fiber-free first electrically insulating layer structure (106) including a first resin (108) on a bottom main surface of a layer body (104), and by arranging a fiber-free second electrically insulating layer structure (110) including a second resin (112) on a top main surface of the layer body (104);
forming a cavity (116) in the stack (102);
inserting a component (114) in the cavity (116) of the stack (102); and
filling at least part of a gap (118) between the component (114) and sidewalls (154) of the stack (102) delimiting the cavity (116) partially with the first resin (108) and partially with the second resin (112).

12. The method according to claim 11, wherein a first dielectric separation foil (140) is provided on a main surface of the first electrically insulating layer structure (106) facing away from the layer body (104) and/or a second dielectric separation foil (144) is provided on a main surface of the second electrically insulating layer structure (110) facing away from the layer body (104), wherein in particular the method comprises completely removing said first dielectric separation foil (142) and said second dielectric separation foil (144) after said curing.

13. The method according to claim 11 or 12, wherein the method comprises filling said at least part of said gap (118) by curing the first resin (108) and the second resin (112), in particular by the application of pressure and/or heat, and thereafter removing the first dielectric separation foil (140) from the main surface of the first electrically insulating layer structure (106) and/or removing the second dielectric separation foil (144) from the main surface of the second electrically insulating layer structure (110) before completing manufacture of the component carrier (100).

14. The method according to claim 12 or 13, wherein the method comprising removing a portion of the layer body (104), a portion of the first electrically insulating layer structure (106), a portion of the second electrically insulating layer structure (110), a portion of the first dielectric separation foil (142) and a portion of the second dielectric separation foil (144) for forming said cavity (116).

15. The method according to any of claims 11 to 14, wherein the method comprises forming a fiducial mark (142) in and/or on the layer body (104) before arranging the first electrically insulating layer structure (106) and the second electrically insulating layer structure (110) on the layer body (104).

16. The method according to any of claims 11 to 15, wherein the method comprises sputtering an electrically conductive sputtering layer (134) directly on at least one pad (132) of the component (114) and/or directly on at least one of the first electrically insulating layer structure (106) and the second electrically insulating layer structure (110).

17. The method according to any of claims 11 to 16, wherein the method comprises attaching a temporary carrier (146) to the stack (102) for closing the cavity (116) prior to inserting the component (114) into the cavity (116) and on the temporary carrier (146), wherein in particular the method comprises removing the temporary carrier (146) after said curing.

18. The method according to any of claims 11 to 17, wherein the method comprises:
arranging the first electrically insulating layer structure (106) in an at least partially uncured state on the bottom main surface of the layer body (104), and arranging the second electrically insulating layer structure (110) in an at least partially uncured state on the top main surface of the layer body (104); and
subsequently filling said at least part of the gap (118) by curing the first electrically insulating layer structure (106) and by curing the second electrically insulating layer structure (110) simultaneously.
